# EUROPÄISCHE PATENTSCHRIFT

(11) **EP 2 026 643 B1**
(45) Veröffentlichungstag und Bekanntmachung des Hinweises auf die Patenterteilung: **25.05.2011**
(21) Anmeldenummer: 08104693.0
(22) Anmeldetag: 10.07.2008
(51) Int. Cl.: H05K 5/06

(54) **Hermetisch dichtes Gehäuse, insbesondere für elektronische Schaltungen**
Hermetically sealed housing, in particular for electronic switching
Boîtier hermétique, en particulier pour commutations électroniques

(30) Priorität: 17.08.2007 DE 102007038989
(43) Veröffentlichungstag der Anmeldung: 18.02.2009
(73) Patentinhaber: ROBERT BOSCH GMBH, 70442 Stuttgart (DE)
(72) Erfinder: Schmich, Franz, 72793 Pfullingen (DE)

(56) Entgegenhaltungen:
- EP-A2- 1 701 132
- WO-A1-91/07794
- JP-A- 11 168 349
- JP-A- 60 163 518

## Beschreibung

Die vorliegende Erfindung betrifft ein hermetisch dichtes Gehäuse, insbesondere für elektronische Schaltungen, bei dem ein im Wesentlichen rechteckiger Deckel mittels Widerstandsschweißen auf eine Gehäusegrundplatte aufgeschweißt wird. Dabei weist der Deckel an den Randbereichen einen Flansch auf, der flächig auf der Grundplatte aufliegt. Der Deckel weist an den vier Eckbereichen weiterhin jeweils einen vorbestimmten Radius auf und umschließt eine auf der Grundplatte angeordnete Stufe so, dass der Deckelflansch die Stufe der Grundplatte im Inneren des Gehäuses vollständig umschließt. Erfindungsgemäß wird der Deckel auf der Grundplatte durch lediglich vier Berührungspunkte, jeweils einen an jeder Ecke, exakt zentriert, so dass die geraden Abschnitte der seitlichen Deckelwände zur Stufe der Gehäusegrundplatte einen vorbestimmten und umlaufend gleich großen Spalt aufweisen, indem die Zentrierung des Deckels auf der Gehäusegrundplatte derart erfolgt, dass die Innenradien der Ecken des Deckels einen größeren Radius aufweisen, als die Radien der abgerundeten Ecken der auf der Grundplatte umlaufenden Stufe.

### Stand der Technik

Aus dem Stand der Technik sind zahlreiche hermetisch dichte Gehäuse bekannt, die durch Widerstandsschweißen eines Deckels auf eine Gehäusegrundplatte hergestellt werden. Dabei weisen diese Gehäuse zwischen der Deckelseitenwand und der Stufe der Grundplatte einen umlaufenden, gleich großen Spalt auf, so dass der Deckel beim Widerstandsschweißen verrutschen kann und eventuelle Schweißspritzer durch aufgeschmolzenes Material in das Innere des hermetisch dichten Gehäuses spritzen können.

Ein solches Gehäuse ist aus dem Dokument JP-A-11 168 349 bekannt.

Offenbarung der Erfindung

Der Kern der vorliegenden Erfindung ist es, ein hermetisch dichtes Gehäuse anzugeben, bei dem der Deckel und die Gehäusegrundplatte derart aufeinander abgestimmt sind, dass sich der Gehäusedeckel während dem Widerstandsschweißen selbstständig exakt auf der Gehäusegrundplatte justiert und dabei der Spalt zwischen den Deckelseitenwänden und der Gehäusegrundplatte so klein dimensioniert ist, dass gleichzeitig eventuelle Schweißspritzer durch das Widerstandsschweißen nicht in das Gehäuseinnere gelangen können. Erfindungsgemäß wird dieses durch die Merkmale des unabhängigen Anspruchs gelöst. Vorteilhafte Weiterbildungen und Ausgestaltungen ergeben sich aus den Unteransprüchen.

Vorteilhaft ist dabei, dass die Seitenwände des Deckels und die Stufe der Gehäusegrundplatte so dimensioniert sind, dass sich die Deckelseitenwände und die Stufe der Gehäusegrundplatte an jeder Ecke in nur einem Punkt berühren. Diese Berührungspunkte an jeder Gehäuseecke ermöglichen eine exakte Selbstjustage des Deckels auf der Grundplatte während dem Widerstandsschweißen.

Weiterhin ist es vorteilhaft, dass der Flansch des Deckels auf der Gehäusegrundplatte mittels Widerstandsschweißen befestigt wird. Hierdurch wird eine hermetisch dichte Versiegelung des Gehäuses erreicht, da der Deckelflansch umlaufend auf der Gehäusegrundplatte befestigt wird.

Weiterhin ist es vorteilhaft, dass der Bereich der Gehäusegrundplatte, auf dem der Flansch des Deckels verschweißt wird, einen Schweißrand aufweist, der als umlaufende Erhöhung, insbesondere mit V-förmigem Querschnitt, ausgeführt ist. Diese umlaufende Erhöhung, die als Schweißrand dient, besteht dabei vorteilhafterweise aus dem Grundmaterial Stahl, das mit einer Nickel-Oberfläche überzogen ist. Dieser Schweißrand kann hierbei einstückig mit der Herstellung der Grundplatte hergestellt werden. Durch diesen umlaufenden, erhöhten Schweißrand fließt während der Widerstandsschweißen der Großteil des Schweißstromes, wodurch insbesondere das Material des Schweißrandes zuerst aufschmilzt und dieser Wulst in das Material des Flansches des Deckels eindringt. Dadurch wird eine besonders belastbare Schweißverbindung erzeugt, die zusätzlich Undichtigkeiten des hermetisch dichten Gehäuses vermeidet.

Weiterhin ist es vorteilhaft, dass der Deckel und die Gehäusegrundplatte aus Metall gefertigt sind. Hierdurch ergibt sich der Vorteil, dass Wärme, die im Inneren des Gehäuses entsteht, effektiv nach außen geleitet wird, sowie dass eine große Störfestigkeit gegen elektromagnetische Strahlung erreicht wird. Weiterhin ermöglicht die Fertigung aus einem metallischen Material, dass Deckel und Gehäusegrundplatte mittels des Widerstandsschweißverfahrens miteinander verbunden werden können.

Vorteilhafter Weise sind im Inneren des Deckels Bauelemente angeordnet, die gegenüber den Bauelementen auf der Grundplatte exakt zu justieren sind. Alternativ kann auch vorgesehen sein, dass das hermetisch dichte Gehäuse mittels des Deckelteils an einem weiteren Trägerelement befestigt wird, so dass die Genauigkeit der Funktionsfähigkeit mikromechanischer Bauteile im Inneren von der Genauigkeit der Justage des Deckels zur Gehäusegrundplatte abhängig ist. Insbesondere bei der Ausführung von Drehratensensoren ist es vorteilhaft, dass das hermetisch dichte Gehäuse mittels des Deckelteils in eine Drehratensensorhalterung eingepresst wird, so dass die Genauigkeit der Funktions der mikromechanischen Bauelemente auf der Grundplatte von der Justage der Deckels zur Gehäusegrundplatte abhängt.

Vorteilhafter Weise ist der vorbestimmte Spalt zwischen den geraden Abschnitten der seitlichen Deckelwände und der Stufe der Gehäusegrundplatte so bemessen, dass während dem Widerstandsschweißen keine Schweißspritzer ins Innere des Gehäuses gelangen. Dies ist von Bedeutung, wenn im Inneren des hermetisch dichten Gehäuses offene Halbleiterchips oder mikromechnaische Bauteile verbaut sind, die durch eindringende Metallpartikel infolge des Widerstandsschweißens in ihrer Funktion beeinträchtigt oder gar zerstört werden würden. Hierdurch wird vorteilhafter Weise die Ausschussrate bei der Deckelmontage wirkungsvoll verringert. Besonders Vorteilhaft ist dabei, dass der vorbestimmte Spalt etwa 0,05 mm breit ist.

Weiterhin ist es vorteilhaft, dass das Gehäuse einen Drehratensensor beinhaltet, wie er beispielsweise in Kraftfahrzeugen eingesetzt wird.

### Kurze Beschreibung der Zeichnungen

Nachfolgend wird ein Ausführungsbeispiel der Erfindung anhand von Zeichnungen erläutert. Es zeigen
- Figur 1: eine Gesamtansicht des erfindungsgemäß hergestellten, hermetisch dichten Gehäuses,
- Figur 2: eine Skizze der Draufsicht auf eine der Ecken des erfindungsgemäßen Gehäuses,
- Figur 3: eine Skizze in Schnittdarstellung in diagonaler Richtung durch eine Gehäuseecke, sowie
- Figur 4: eine Skizze einer Schnittdarstellung durch einen der geraden Abschnitte des erfindungsgemäßen Gehäuses.

### Ausführungsform der Erfindung

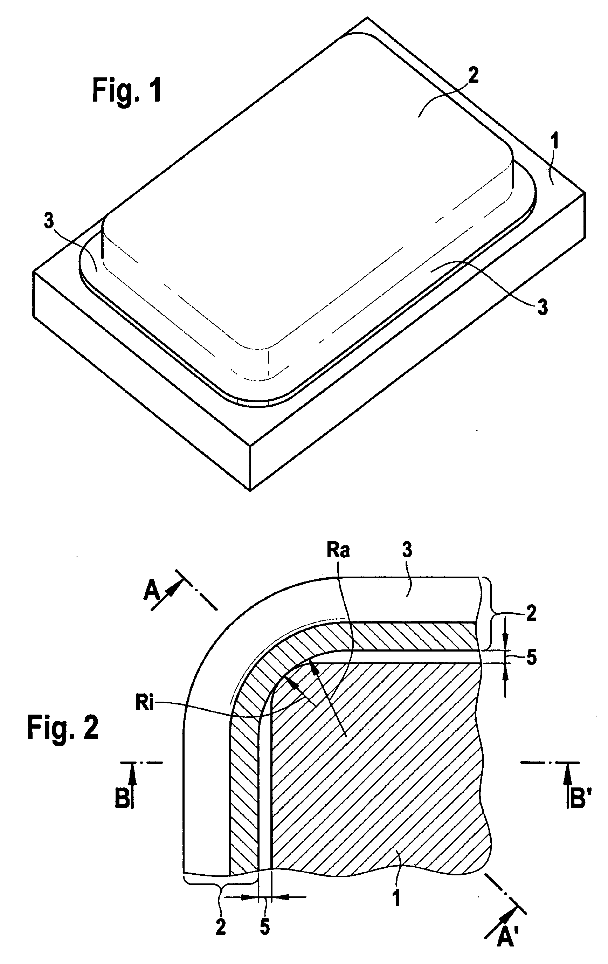

In Figur 1 ist die Gesamtdarstellung eines erfindungsgemäßen Gehäuses aufgezeigt. Zu erkennen ist eine Gehäusegrundplatte 1, die eine nicht dargestellte Stufe aufweist, die derart ausgestaltet ist, dass der innere Bereich der Gehäusegrundplatte gegenüber dem sichtbaren, äußeren Rand erhöht ist und auf dieser erhöhten Stufe elektronische Bauelemente und/oder ein Drehratensensor angebracht sind. Auf der Kante der beschriebenen Stufe der Gehäusegrundplatte 1 ist ein Deckel 2 aufgesetzt, der die erhöhte Stufe der Trägergrundplatte im Inneren aufnimmt und gemeinsam mit der Gehäusegrundplatte 1 das hermetisch dichte Gehäuse bildet. Weiterhin ist am äußeren Rand des Deckels 2 ein umlaufender Deckelflansch 3 dargestellt, der parallel zur Deckeldecke und in etwa senkrecht zu den Deckelwänden ausgeführt ist und flächig auf der Gehäusegrundplatte 1 aufliegt. Mittels diesem Deckelflansch 3 ist es möglich, den Deckel 2 und die Gehäusegrundplatte 1 miteinander zu verschweißen, beispielsweise durch ein aus dem Stand der Technik bekanntes Widerstandsschweißverfahren.

In Figur 2 ist skizzenhaft eine exemplarische Ecke des in Figur 1 dargestellten Gehäuses in Draufsicht dargestellt. Zu erkennen ist die auf der Gehäusegrundplatte 1 angeordnete Stufe, die diagonal schraffiert ist und an den Ecken Rundungen aufweist, wobei die Ecken der Stufe mit dem Radius Ri abgerundet sind. Auf dieser Gehäusegrundplatte 1 sind im Inneren des Gehäuses elektronische Schaltungen oder mikromechanische Bauelemente angeordnet. Weiterhin ist der Deckel 2 dargestellt, der aus einem ebenfalls schraffierten Bereich besteht, der eine Schraffur orthogonal zur Schraffur der Stufe der Gehäusegrundplatte 1 aufweist, und der die senkrecht stehende Deckelwand repräsentiert und aus dem unschraffierten Bereich 3 besteht, der den parallel zur Deckeldecke ausgerichteten Deckelflansch 3 darstellt, der flächig auf der Gehäusegrundplatte 1 aufliegt. Hierbei wurde die Ecke des Gehäusedeckels so ausgeführt, dass die Innenseite abgerundeten Ecken der Deckelwände ebenfalls einen vordefinierten Radius Ra aufweisen, der gegenüber dem Radius Ri der Stufe der Gehäusegrundplatte 1 einen größeren Radius aufweist. Die Abmessungen der Stufe auf der Gehäusegrundplatte 1, sowie die Innenabmessungen des Gehäusedeckels 2 sind so bemessen, dass zwei gegenüberliegende Deckelwände ein größeres lichtes Maß aufweisen, als die Stufe der Gehäusegrundplatte 1 breit ist. Hierdurch ergibt sich, dass die geraden Abschnitte zwischen der Stufe der Gehäusegrundplatte 1 und den Deckelwänden einen allseits gleich großen Spalt 5 aufweisen, der jedoch so gering bemessen wurde, dass beim Widerstandsschweißen des Deckelflansches 3 auf der Gehäusegrundplatte 1 keine Schweißspritzer durch aufgeschmolzenes Material in das Innere des hermetisch dichten Gehäuses gelangen können. Die Radien der mittels dem Radius Ri abgerundeten Ecken der Stufe der Gehäusegrundplatte 1, die Innenradien Ra der Deckelwände, sowie die Abmessungen sowohl der Stufe, als auch der Gehäusewände sind nun so bemessen, dass in den Eckbereichen jeweils in jeder Ecke sich der Deckel 2 und die Gehäusegrundplatte 1 in exakt einem Punkt berühren. Wird nun zum Widertandsschweißen der Deckel 2 auf die Gehäusegrundplatte 1 aufgedrückt, so zentriert sich das Deckelgehäuse 2 durch die Stufe der Gehäusegrundplatte 1 exakt über der Gehäusegrundplatte, da der mechanische Widerstand lediglich in vier Eckpunkten entsteht, dieser mechanische Widerstand jedoch leicht überwunden werden kann und das Deckelgehäuse 2 auf die Gehäusegrundplatte 1 soweit niedergedrückt werden kann, dass der Deckelflansch 3 flächig auf der Gehäusegrundplatte 1 zum Liegen kommen. Anschließend wird eine Widerstandsschweißung durchgeführt, bei der der Gehäuseflansch ringsum mit der Gehäusegrundplatte verschweißt wird. Da die Gehäusegrundplatte 1 üblicherweise aus einem elektrisch leitfähigen Material hergestellt ist, um die Widerstandsschweißung überhaupt zu ermöglichen, besteht die Gefahr, dass durch Kontaktstellen zwischen dem Deckel 2 und der Kante der Stufe der Gehäusegrundplatte 1 Ströme fließen, die nicht über den Deckelflansch 3 fließen und damit einen unerwünschten Leckstrom darstellen. Durch die spezielle Dimensionierung des Deckels und der Gehäusegrundplatte berühren sich Deckel und Grundplatte jedoch nur in jeweils einem Punkt pro Ecke, so dass diese Leckströme extrem gering sind und die erfindungsgemäße Verbindung zwischen Deckel und Gehäusegrundplatte mittels Widerstandsschweißen erst ermöglicht wird.

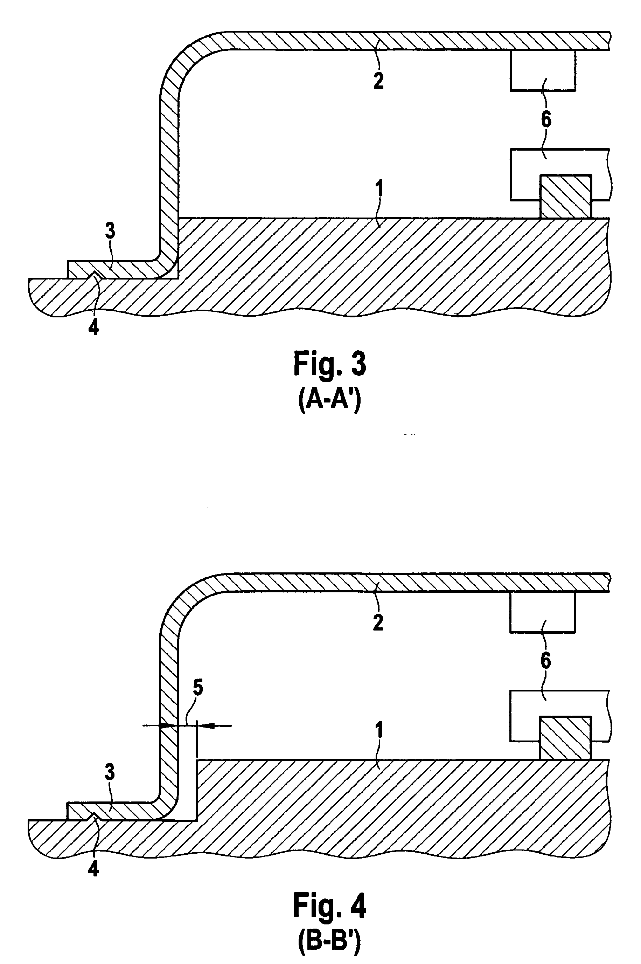

In Figur 3 ist eine Schnittdarstellung aufgezeigt, die sich entlang der Schnittlinie A-A' gemäß Figur 2 ergibt. Hierbei wurde der Deckel und die Gehäusegrundplatte diagonal durch den Kontaktpunkt zwischen Deckel 2 und der Stufe der Gehäusegrundplatte 1 gelegt, so dass hier erkennbar ist, dass zwischen der Gehäusegrundplatte 1 und dem Deckel 2 kein Spalt vorhanden ist und die Seitenwand des Deckels 2 unmittelbar an der Stufe der Gehäusegrundplatte 1 anliegt. Weiterhin ist der Gehäuseflansch 3 zu erkennen, der flächig auf der Gehäusegrundplatte 1 aufliegt und mittels Widerstandsschweißen mit dieser verbunden werden kann. Es ist ebenfalls der Schweißrand 4 dargestellt, der als umlaufende, V-förmige Erhöhung auf der Gehäusegrundplatte 1 in dem Bereich, ausgeführt ist, der mit dem Flansch 3 des Deckels 2 verschweißt wird.

In Figur 4 ist im Vergleich zu Figur 3 ein Schnitt durch eine der geraden Abschnitte zwischen Deckel 2 und Gehäusegrundplatte 1 dargestellt, bei dem im Gegensatz zu Figur 3 ein Spalt 5 zwischen der Deckelseitenwand und der Gehäusegrundplatte 1 vorgesehne ist, wodurch Leckströme, die über die Stufe der Gehäusegrundplatte 1 abfließen, vermieden werden. Auch in Figur 4 ist der Deckelflansch 3, sowie der Schweißrand 4 dargestellt. Besonders vorteilhaft ist diese Vorrichtung für den Fall, dass Bauteile an der Innenseite der Deckeldecke 2 befestigt sind, die exakt gegenüber korrespondierenden Bauteilen zu justieren sind, die auf der Gehäusegrundplatte angeordnet sind.

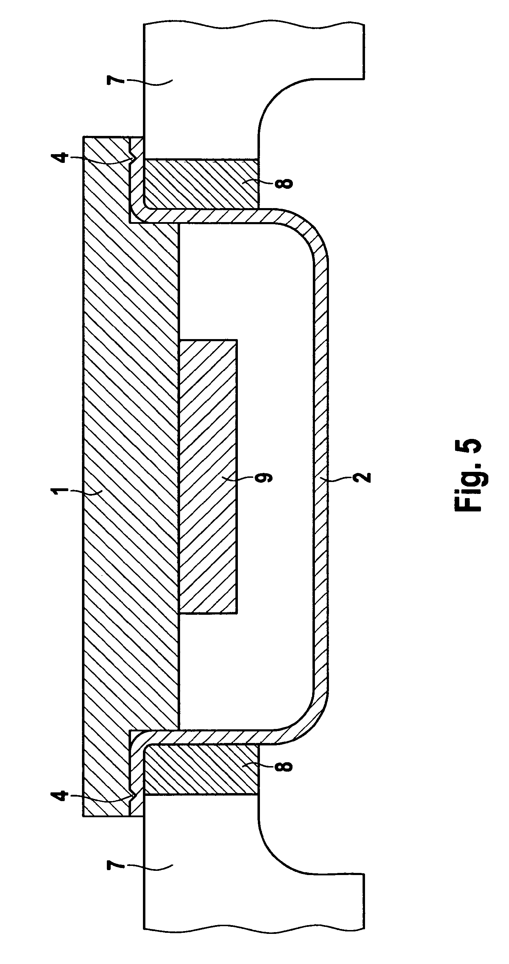

In Figur 5 ist die Montage des hermetisch dichten Gehäuses an einem Gehäuseträger 7 gezeigt, wobei das hermetisch dichte Gehäuse mittels des Deckels 2 in eine Halterung 8 eingepresst ist. Diese Montage ist besonders bei einer Fahrdynamikregelung (ESP) vorteilhaft, bei der im Inneren des Gehäuses auf der Gehäusegrundplatte 1 mikromechanische Elemente 9 zur Realisierung eines Drehratensensors befinden. Dabei ist die Genauigkeit der Funktionsweise des Drehratensensors einerseits von der Genauigkeit des Einpressens des fertig montierten Gehäuses, bestehend aus Deckel 2 und Gehäusegrundplatte 1, in der Halterung 8 des Gehäuseträgers 7 abhängig; zusätzlich ist die Genauigkeit der Funktionsweise des Drehratensensors von der Genauigkeit der Montage des Deckels 2 bezüglich der Gehäusegrundplatte 1 abhängig, weshalb in diesem Fall eine besonders exakte Montage des Deckels 2 auf der Gehäusegrundplatte 1 notwendig ist.

Durch die beschriebene Erfindung wird eine besonders exakte Montage des Deckels 2 auf der Gehäusegrundplatte 1 ermöglicht.

## Patentansprüche

1. Hermetisch dichtes Gehäuse, insbesondere für elektronische Schaltungen, bei dem ein im wesentlichen rechteckiger Deckel (2) mittels Widerstandsschweißen auf eine Gehäusegrundplatte (1) aufgeschweißt wird, wobei der Deckel (2) an den Randbereichen einen Flansch (3) aufweist, der flächig auf der Gehäusegrundplatte (1) aufliegt und der Deckel (2) an den Eckbereichen des Flansches (3) jeweils einen vorbestimmten Radius (Ra) aufweist und wobei die Gehäusegrundplatte (1) derart abgestuft ist, dass der Deckelflansch (3) die Stufe der Gehäusegrundplatte (1) im Inneren des Gehäuses vollständig umschließt, **dadurch gekennzeichnet, dass** die geraden Abschnitte der seitlichen Deckelwände (3) zur Stufe der Gehäusegrundplatte (2) einen vorbestimmten und umlaufend gleichen Spalt (5) aufweisen indem die Zentrierung des Deckels (2) auf der Gehäusegrundplatte (1) derart erfolgt, dass die Innenradien (Ri) der Ecken des Deckels (2) einen größeren Radius (Ra) aufweisen als die Radien (Ri) der abgerundeten Ecken der auf der Gehäusegrundplatte (1) umlaufenden Stufe.

2. Vorrichtung nach Anspruch 1, **dadurch gekennzeichnet, dass** die Seitenwände des Deckels (2) und die Stufe der Gehäusegrundplatte (1) so dimensioniert sind, dass sich die Deckelseitenwände und die Stufe der Gehäusegrundplatte (1) an jeder Ecke in nur einem Punkt berühren.

3. Vorrichtung nach Anspruch 1 oder 2, **dadurch gekennzeichnet, dass** der Flansch des Deckels (2) auf der Gehäusegrundplatte (1) mittels Widerstandsschweißen befestigt wird.

4. Vorrichtung nach einem der vorhergehenden Ansprüche, **dadurch gekennzeichnet, dass** die Gehäusegrundplatte (1) außerhalb der Stufe, in dem Bereich, auf dem der Flansch (3) des Deckels (2) zum Liegen kommt, einen Schweißrand (4) aufweist, der als umlaufende Erhöhung ausgeführt ist.

5. Vorrichtung nach Anspruch 4, **dadurch gekennzeichnet, dass** der Schweißrand (4) im Querschnitt V-förmig ausgeführt ist.

6. Vorrichtung nach Anspruch 4 oder 5, **dadurch gekennzeichnet, dass** der Schweißrand (4) aus dem Grundmaterial Stahl besteht und mit einer Nickel-Oberfläche versehen ist.

7. Vorrichtung nach einem der vorhergehenden Ansprüche, **dadurch gekennzeichnet, dass** der Deckel (2) und die Gehäusegrundplatte (1) aus Metall gefertigt sind.

8. Vorrichtung nach einem der vorhergehenden Ansprüche, **dadurch gekennzeichnet, dass** im Inneren des Deckels (2) Bauelemente angeordnet sind, die gegenüber den Bauelementen (6) auf der Gehäusegrundplatte (1) exakt zu justieren sind.

9. Vorrichtung nach einem der vorhergehenden Ansprüche, **dadurch gekennzeichnet, dass** das hermetisch Dichte Gehäuse mittels des Deckel (2) an einem Gehäuseträger befestigt ist und die Genauigkeit der Funktionsweise der im Gehäuseinneren vorgesehenen Bauelemente von der Genauigkeit der Befestigung des Deckels (2) bezüglich der Gehäusegrundplatte (1) ergibt.

10. Vorrichtung nach einem der vorhergehenden Ansprüche, **dadurch gekennzeichnet, dass** der vorbestimmte Spalt (5) zwischen den geraden Abschnitten der seitlichen Deckelwände (2) und der Stufe der Gehäusegrundplatte (1) so bemessen ist, dass während dem Widerstandsschweißen keine Schweißspritzer ins Innere des Gehäuses gelangen.

11. Vorrichtung nach Anspruch 10, **dadurch gekennzeichnet, dass** der vorbestimmte Spalt (5) 0,05 Millimeter beträgt.

12. Vorrichtung nach einem der vorhergehenden Ansprüche, **dadurch gekennzeichnet, dass** das Gehäuse (1,2) einen Drehratensensor beinhaltet

## Claims

1. Hermetically sealed housing, in particular for electronic circuits, in which a substantially rectangular cover (2) is welded onto a housing base plate (1) by means of resistance welding, the cover (2) having at the border regions a flange (3), which rests flatly on the housing base plate (1), and the cover (2) having at each of the corner regions of the flange (3) a predetermined radius (Ra) and the housing base plate (1) being stepped in such a way that the cover flange (3) completely encloses the step of the housing base plate (1) inside the housing, **characterized in that** the straight portions of the lateral cover walls (3) have a predetermined and peripherally equal gap (5) from the step of the housing base plate (2) as a result of the centring of the cover (2) on the housing base plate (1) taking place in such a way that the inner radii (Ri) of the corners of the cover (2) have a greater radius (Ra) than the radii (Ri) of the rounded corners of the step running around the periphery of the housing base plate (1).

2. Device according to Claim 1, **characterized in that** the side walls of the cover (2) and the step of the housing base plate (1) are dimensioned such that the cover side walls and the step of the housing base plate (1) are in contact at only one point in each corner.

3. Device according to Claim 1 or 2, **characterized in that** the flange of the cover (2) is fastened on the housing base plate (1) by means of resistance welding.

4. Device according to one of the preceding claims, **characterized in that** the housing base plate (1) has outside the step, in the region on which the flange (3) of the cover (2) comes to lie, a welding border (4), which is configured as a peripheral elevation.

5. Device according to Claim 4, **characterized in that** the welding border (4) is configured as V-shaped in cross section.

6. Device according to Claim 4 or 5, **characterized in that** the welding border (4) consists of a steel base material and is provided with a nickel surface.

7. Device according to one of the preceding claims, **characterized in that** the cover (2) and the housing base plate (1) are produced from metal.

8. Device according to one of the preceding claims, **characterized in that** arranged inside the cover (2) are components which can be adjusted exactly with respect to the components (6) on the housing base plate (1).

9. Device according to one of the preceding claims, **characterized in that** the hermetically sealed housing is fastened by means of the cover (2) on a housing support and the accuracy of the operation of the components provided inside the housing depends on the accuracy of the fastening of the cover (2) with respect to the housing base plate (1).

10. Device according to one of the preceding claims, **characterized in that** the predetermined gap (5) between the straight portions of the lateral cover walls (2) and the step of the housing base plate (1) is dimensioned such that no welding spatter gets inside the housing during the resistance welding.

11. Device according to Claim 10, **characterized in that** the predetermined gap (5) is 0.05 millimetre.

12. Device according to one of the preceding claims, **characterized in that** the housing (1, 2) contains a rotational speed sensor.

## Revendications

1. Boîtier hermétiquement étanche, en particulier pour des circuits électroniques, dans lequel un couvercle sensiblement rectangulaire (2) est soudé sur une plaque de base de boîtier (1) au moyen d'un soudage par résistance, le couvercle (2) présentant au niveau des régions de bord une bride (3), qui repose à plat sur la plaque de base de boîtier (1) et le couvercle (2) présentant au niveau des régions de coin de la bride (3) à chaque fois un rayon prédéterminé (Ra), et la plaque de base de boîtier (1) étant étagée de telle sorte que la bride de couvercle (3) entoure complètement l'étage de la plaque de base de boîtier (1) à l'intérieur du boîtier, **caractérisé en ce que** les portions droites des parois de couvercle latérales (3) présentent, par rapport à l'étage de la plaque de base de boîtier (1), une fente (5) prédéterminée et identique sur la périphérie, le centrage du couvercle (2) s'effectuant sur la plaque de base de boîtier (1) de telle sorte que les rayons internes (Ri) des coins du couvercle (2) présentent un plus grand rayon (Ra) que les rayons (Ri) des coins arrondis de l'étage périphérique sur la plaque de base de boîtier (1).

2. Dispositif selon la revendication 1, **caractérisé en ce que** les parois latérales du couvercle (2) et l'étage de la plaque de base de boîtier (1) sont dimensionnés de telle sorte que les parois latérales du couvercle et l'étage de la plaque de base de boîtier (1) se touchent seulement en un point au niveau de chaque coin.

3. Dispositif selon la revendication 1 ou 2, **caractérisé en ce que** la bride du couvercle (2) est fixée sur la plaque de base de boîtier (1) au moyen d'un soudage par résistance.

4. Dispositif selon l'une quelconque des revendications précédentes, **caractérisé en ce que** la plaque de base de boîtier (1) présente à l'extérieur de l'étage, dans la région sur laquelle la bride (3) du couvercle (2) vient s'appliquer, un bord de soudage (4) qui est réalisé sous forme de rehaussement périphérique.

5. Dispositif selon la revendication 4, **caractérisé en ce que** le bord de soudage (4) est réalisé en forme de V en section transversale.

6. Dispositif selon la revendication 4 ou 5, **caractérisé en ce que** le bord de soudage (4) se compose d'acier en tant que matériau de base, et est pourvu d'une surface en nickel.

7. Dispositif selon l'une quelconque des revendications précédentes, **caractérisé en ce que** le couvercle (2) et la plaque de base de boîtier (1) sont fabriqués en métal.

8. Dispositif selon l'une quelconque des revendications précédentes, **caractérisé en ce que** des composants sont disposés à l'intérieur du couvercle (2), lesquels doivent être ajustés exactement par rapport aux composants (6) sur la plaque de base de boîtier (1).

9. Dispositif selon l'une quelconque des revendications précédentes, **caractérisé en ce que** le boîtier hermétiquement étanche est fixé au moyen du couvercle (2) sur un support de boîtier, et la précision de fonctionnement des composants prévus à l'intérieur du boîtier résulte de la précision de la fixation du boîtier (2) par rapport à la plaque de base de boîtier (1).

10. Dispositif selon l'une quelconque des revendications précédentes, **caractérisé en ce que** la fente prédéterminée (5) entre les portions droites des parois de couvercle latérales (2) et l'étage de la plaque de base de boîtier (1) est dimensionnée de telle sorte qu'aucune projection de soudure ne pénètre à l'intérieur du boîtier pendant l'opération de soudage par résistance.

11. Dispositif selon la revendication 10, **caractérisé en ce que** la fente prédéterminée (5) mesure 0,05 millimètre.

12. Dispositif selon l'une quelconque des revendications précédentes, **caractérisé en ce que** le boîtier (1, 2) contient un capteur de vitesse de rotation.
